## Europäisches Patentamt

## European Patent Office

## Office européen des brevets

(11) Veröffentlichungsnummer: **0 360 914 B1**

---

(12) **EUROPÄISCHE PATENTSCHRIFT**

(45) Veröffentlichungstag der Patentschrift: **27.07.94**

(51) Int. Cl.$^5$: **H03M 1/10**, //H03M1/46, H03M1/80

(21) Anmeldenummer: **88116230.9**

(22) Anmeldetag: **30.09.88**

---

(54) **Selbstkalibrierender A/D- und D/A-Wandler.**

---

(43) Veröffentlichungstag der Anmeldung:
**04.04.90 Patentblatt 90/14**

(45) Bekanntmachung des Hinweises auf die Patenterteilung:
**27.07.94 Patentblatt 94/30**

(84) Benannte Vertragsstaaten:
**AT DE FR GB IT NL**

(56) Entgegenhaltungen:
**US-A- 4 077 035**
**US-A- 4 399 426**

**IBM TECHNICAL DISCLOSURE BULLETIN, Band 19, Nr. 6, November 1976, Seiten 2360-2362, New York, US; Y.S. YEE: "Adaptive reference voltage adjustment for ananalog-to-digital converter"**

**CONFERENCE RECORD, 1978 INTERNATIO-NAL CONFERENCE ON COMMUNICATIONS, Toronto, 4.-7. Juni 1978, Band 3, Seiten 45.2.1-45.2.4, IEEE; T.J. MROZ: "CMOS codec sets for telecommunications"**

(73) Patentinhaber: **SIEMENS AKTIENGESELL-SCHAFT**
**Wittelsbacherplatz 2**
**D-80333 München(DE)**

(72) Erfinder: **Draxelmayr, Dieter, Dipl.-Ing., Dr.-Tech.**
**Tschinowitscherweg 46**
**A-9500 Villach(AT)**

---

## Beschreibung

Die Erfindung betrifft einen selbstkalibrierenden A/D- und D/A-Wandler nach dem Oberbegriff des Patentanspruchs 1.

Die wichtigste und kritischste Schnittstelle zwischen verschiedenen Typen von Systemen ist gewöhnlich die Verbindung zwischen analogen und digitalen Teilen der Systeme. Die Schnittstelle zwischen einem digitalen Kreis und einem analogen Kreis benötigt dabei einen D/A-Wandler, während die Schnittstelle zwischen einem analogen Kreis und einem digitalen Kreis entsprechend einen A/D-Wandler erfordert. Ein natürlich real nicht existierender idealer Wandler setzt ein digitales bzw. analoges Signal ohne Verzögerung und ohne Fehler in ein analoges bzw. digitales Signal um.

Bei vielen Typen von A/D- und D/A-Wandlern benötigt man Referenzelemente, die aus einer vorgegebenen Referenzgröße weitere Größen ableiten, die für eine Umsetzung benötigt werden. Diese Referenzelemente bilden ein gewichtetes Netzwerk. In der Praxis werden die gewichteten Netzwerke meistens durch Widerstände, Kondensatoren oder Transistoren realisiert. Derartige Wandler arbeiten beispielsweise nach dem Verfahren der sukzessiven Approximation, für die als ein Vertreter ein Wandler mit Ladungsumverteilung (charge redistribution) gelten kann, bei dem das gewichtete Netzwerk aus Kapazitäten besteht.

Bei Wandlern mit gewichtetem Netzwerk ist es wichtig, daß die gewichteten Elemente zueinander in einem genau vorgegebenen Verhältnis stehen. Für hochgenaue Wandler müssen die gewichteten Elemente hochgenau sein. Probleme ergeben sich jedoch, weil die gewichteten Elemente nicht genau genug hergestellt werden können. Üblicherweise erfolgt deshalb eine Korrektur, beispielsweise durch Trimmverfahren oder durch die Verwendung von Korrektur-PROMs, die jedoch Nachteile aufweisen.

Eine weitere Möglichkeit zur Kalibrierung von A/D- bzw. D/A-Wandlern besteht in der Möglichkeit der Selbstkalibrierung und ist beispielsweise aus der US-A-4,451,821 (Domogalla) und der Veröffentlichung von H.-S. Lee und D. Hodges, "Self-Calibration Technique for A/D-Converters", IEEE Transactions on Circuits and Systems, Vol. CAS-30, No. 3, March 1983, p. 188 bekannt.

Die beschriebenen Verfahren der sukzessiven Approximation setzen ein binär gewichtetes Netzwerk voraus, bei dem das kleinste Element doppelt vorhanden ist. Dann ist im Idealfall ein gewichtetes Element identisch gleich der Summe aller niedriger gewichteten Elemente (Bits). Bei dieser Selbstkalibrierung wird schrittweise für jedes gewichtete Element des Netzwerks die Abweichung von der Gewichtungssumme aller jeweils niedriger gewichteten Elemente festgestellt. Aus dieser Differenz, die idealerweise Null ist, kann offensichtlich der jedem gewichteten Element zuzuordnende Gewichtungsfehler bestimmt werden, der abgespeichert wird und dann bei einem Wandlungsvorgang zur Korrektur des Ergebnisses benutzt werden kann. Dieser Gewichtungsfehler wird üblicherweise mit Hilfe eines gewichteten Korrekturnetzwerks ermittelt und abgespeichert. Zur Zuordnung der Korrektur-Gewichtungen zu den einzelnen gewichteten Elementen ist eine Recheneinheit, beispielsweise ein Microcomputer, erforderlich.

Aus der US-A-4,399,426 (Tan) ist bekannt, eine Mehrzahl von kapazitiven Netzwerken zur Fehlerkorrektur vorzusehen.

In der genannten Veröffentlichung von Lee und Hodges ist ein selbstkalibrierender A/D-Wandler beschrieben, der ein gewichtetes kapazitives Hauptnetzwerk und ein aus Widerstandsleitern bestehendes Teil-Netzwerk als Wandlernetzwerk benutzt. Das Kalibrier- und Korrekturnetzwerk besteht ebenfalls aus Widerstandsleitern. Die beiden Widerstandsnetzwerke werden über jeweils einen Koppelkondensator an den gemeinsamen Knotenpunkt des Hauptnetzwerks angeschlossen, der auch auf einen Eingang eines nachgeschalteten Komparators führt. Der beschriebene Wandler weist den Nachteil auf, daß durch die Widerstandsnetzwerke auch im statischen Zustand Ströme fließen, die Verluste erzeugen und die die erreichbare Genauigkeit des Wandlers mindern.

Die Patentschrift US-A-4 077 035 (IBM) offenbart ein aus zwei Teilnetzwerken bestehendes kapazitives Wandlernetzwerk, mit einem einem Komparator vorgeschalteten Operationsverstärker. Die verwandte Zeitschrift IBM Technical Disclosure Bulletin, Band 19, Nr.6, November 1976, Seiten 2360-2362 lehrt, ein Korrekturnetzwerk zwecks Justierung der Referenzspannung zwischen Eingang und Ausgang des Operationsverstärkers einzusetzen.

Der Erfindung liegt die Aufgabe zugrunde, einen selbstkalibrierenden A/D- und D/A-Wandler anzugeben, der eine geringe statische Verlustleistung aufweist und eine höhere Wandlergenauigkeit ermöglicht.

Diese Aufgabe wird bei einem selbstkalibrierenden A/D- und D/A-Wandler der eingangs genannten Art erfindungsgemäß durch die Merkmale des kennzeichnenden Teils des Patentanspruchs 1 gelöst.

Die Erfindung hat den Vorteil, daß durch die Verwendung von kapazitiven Netzwerken keine statischen Ströme fließen und keine statischen Spannungsabfälle auftreten, so daß die Verlustleistung minimal ist. Auf diese Weise können wesentliche Fehlerquellen ausgeschaltet werden.

Ausgestaltungen der Erfindung sind in abhängigen Ansprüchen gekennzeichnet.

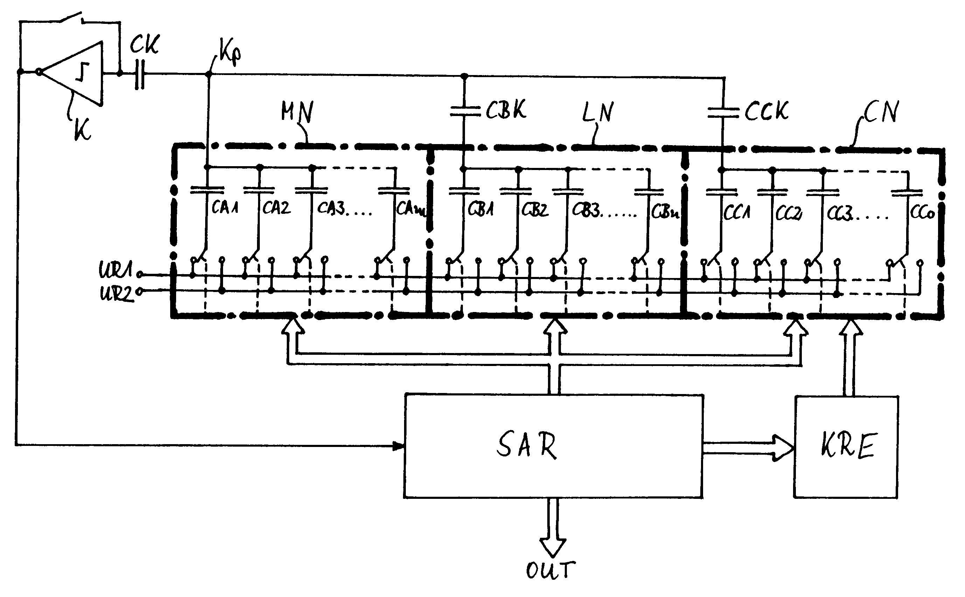

Die Erfindung wird im folgenden anhand eines in der Figur der Zeichnung dargestellten Ausführungsbeispiels näher erläutert. Das Ausführungsbeispiel zeigt einen A/D-Wandler nach dem Verfahren der sukzessiven Approximation mit gewichtetem Kapazitätsnetzwerk.

Der Wandler enthält das gewichtete kapazitive Haupt-Wandlernetzwerk MN mit den Kapazitäten CA1 bis CAm, das kapazitive Teil-Wandlernetzwerk LN mit den Kapazitäten CB1 bis CBn sowie das kapazitive Kalibrier- und Korrekturnetzwerk CN mit den Kapazitäten CC1 bis CCo. Die Kapazitäten der drei Netzwerksbereiche MN, LN und CN sind gewichtet, vorzugsweise binär gewichtet. Jeder der Kapazitäten des Wandlers ist in einem Schalternetzwerk ein gesteuerter Schalter zugeordnet, mit dessen Hilfe die betreffende Kapazität mit einer Klemme UR1 oder UR2 verbunden werden kann, die jeweils eine Referenzspannung führen. Der andere Anschluß jeder Kapazität ist bezüglich jedes der drei Netzwerksbereiche mit einem Summierungspunkt verbunden. Dieser Summierungspunkt ist bei dem Haupt-Wandlernetzwerk MN direkt mit einem Knotenpunkt Kp, für das Teil-Wandlernetzwerk LN und das Kalibrier- und Korrekturnetzwerk CN dagegen über jeweils eine Koppelkapazität CBK bzw. CCK mit dem Knotenpunkt Kp verbunden. Dieser Knotenpunkt Kp ist gegebenenfalls über eine weitere Koppelkapazität CK an einen Eingang eines Komparators K gelegt, dessen Ausgang ein sukzessives Approximationsregister SAR steuert. Das sukzessive Approximationsregister SAR besitzt zum einen Ausgänge, an denen das digitale gewandelte Ausgangssignal abgegriffen werden kann, zum anderen steuert es die den Wandlerkapazitäten zugeordneten, nicht mit Bezugszeichen versehenen Schalter und zum dritten führen Ausgänge auf eine Korrektur- und Recheneinheit KRE. Die Korrektur- und Recheneinheit KRE ihrerseits ist mit dem Kalibrier- und Korrekturnetzwerk CN verbunden.

In der schematischen Anordnung gemäß der Figur sei vorausgesetzt, daß gegebenenfalls vorgesehene Zeitkontrolleinheiten zur Steuerung des sukzessiven Approximationsregisters, eventuell erforderlicher nicht gezeichneter Multiplexer und der Kontroll-und Recheneinheit KRE gemäß üblicher Schaltungen vorgesehen sind. Entsprechend enthält die Kontroll- und Recheneinheit KRE die erforderliche Kalibrierungslogik oder Microprozessoreinheit, Speicherelemente sowie weitere, für den Kalibrier- und Korrekturvorgang erforderliche Elemente.

Die Kapazitäten der drei Netzwerksbereiche MN, LN und CN sind bei vorzugsweise binärer Wichtung in ihrem Wert unabhängig voneinander wählbar. Die Anzahl der Wichtungskapazitäten im Haupt-und Teil-Wandlernetzwerk MN und LN entspricht der Bit-Auflösung des Wandlers. Vorzugsweise ist dabei die Anzahl der Kapazitäten im Haupt-Wandlernetzwerk LN größer oder gleich der Anzahl im Teil-Wandlernetzwerk LN. Bei einem Wandler mit 12-Bit-Auflösung kann beispielsweise das Netzwerk MN acht Kapazitäten enthalten, die eine Auflösung von 8 Bit erlauben, während das Netzwerk LN eine Auflösung von 4 Bit mit vier Wichtungskapazitäten erlaubt. Die kleinste Wichtungskapazität des Teil-Wandlernetzwerks LN ist dabei doppelt ausgelegt. Vorzugsweise besitzt das Teil-Wandlernetzwerk LN noch eine Korrekturkapazität, die dem halben nie drigst wertigen Bit (LSB/2) entspricht. Im Ausführungsbeispiel der Figur bedeutet das bei einem 12-Bit-Wandler, daß das Haupt-Wandlernetzwerk MN Kapazitätswerte von CA1 bis CAm = 128 x CA1 enthält. Im Teil-Wandlernetzwerk LN ist CB1 = 0,5 x CB2 und CB2 = = CB3 sowie CBn = 8 x CB2. Obwohl die niedrigste Wichtungskapazität CB2 des Teil-Wandlernetzwerks LN unabhängig von der niedrigsten Wichtungskapazität CA1 des Haupt-Wandlernetzwerks ist, wird vorzugsweise CB2 ungefähr gleich dem doppelten Wert von CA1 gewählt.

Die Kapazitäten des Kalibrier- und Korrekturnetzwerks CN sind ebenfalls unabhängig von den Wichtungskapazitäten CAi und CBi der beiden Wandler-Netzwerksbereiche. Die Anzahl der Kapazitäten für den Netzwerksbereich CN, d.h. die erreichbare Auflösung, ist frei wählbar und stellt einen Kompromiß zwischen erreichbarer Genauigkeit und Aufwand dar. Im Beispielsfall eines 12-Bit-Wandlers sind vorzugsweise 6 Bit Auflösung vorgesehen, d.h. sechs Kapazitäten. Vorzugsweise ist die kleinste Wichtungskapazität CC1 des Kalibrier- und Korrekturnetzwerks CN ungefähr gleich der Hälfte des Werts für die kleinste Wichtungskapazität CA1 des Haupt-Wandlernetzwerks.

Der Koppelkondensator CBK für das Teil-Wandlernetzwerk LN ist im Falle einer Technologie ohne Streukapazitäten etwa gleich dem Wert der kleinsten Wichtungskapazität CA1 des Haupt-Wandlernetzwerks. Je nach der Größe der durch das Design vorgeschriebene Streukapazitäten ist der Wert in der Praxis jedoch größer, d.h. er liegt zwischen dem 1- und 1,4-fachen Wert der kleinsten Wichtungskapazität CA1 des Haupt-Wandlernetzwerks MN. Da der zu korrigierende Fehler üblicherweise kleiner als CA1 ist, ist CBK typisch größer als die Koppelkapazität CCK des Kalibrier- und Korrekturnetzwerks CN. Diese Koppelkapazität CCK ist vom Wert der kleinsten Wichtungskapazität CA1 des Haupt-Wandlernetzwerks abhängig. Ihre Größe richtet sich nach der Kalibriergenauigkeit bzw. dem Fehler, der maximal auskalibriert werden kann. Je nach dem Design der Wandleranordnung liegt sein Wert zwischen dem 0,1- bis 1-fachen Wert der kleinsten Wichtungskapazität CA1 des Netzwerks MN.

Die erfindungsgemäße Wandleranordnung eignet sich sowohl für Selbstkalibrierverfahren, die von der kleinsten Wichtungskapazität und der Annahme ausgehen, daß diese ideal sei, als auch für Verfahren, die die Summe aller Wichtungskapazitäten als ideal annimmt. Beim letzteren Verfahren ergibt sich eine Reduktion des Schaltungsaufwands hinsichtlich der Korrektur, dem aber möglicherweise ein größerer Aufwand im digitalen Bereich entgegensteht. Dies wirkt sich jedoch nicht nachteilig aus, da gerade bei modernen Technologieprozessen sehr kleine Strukturen für digitale Logik gebaut werden können, während höherer Schaltungsaufwand auf der Analogseite wesentlich aufwendiger zu realisieren ist.

In der erfindungsgemäßen Wandleranordnung werden Korrekturladungen mittels des Kalibrier- und Korrekturnetzwerks CN gebildet und über den Koppelkondensator CCK eingekoppelt. Da das Netzwerk LN für die niedrigerwertigen Bits ebenfalls kapazitiv ausgebildet ist, besitzt der Wandler gegenüber bekannten Wandlerns mit Widerstandsleitern den Vorteil, daß keine statischen Ströme fließen. Dadurch wird einerseits die Verlustleistung reduziert und andererseits entstehen keine statischen Spannungsabfälle. Auf diese Weise werden wesentliche Fehlerquellen, wie z.B. Spannungsabfälle von der Platine bis ins Schaltungsinnere zu den Anschlüssen für die Referenzpotentiale, ausgeschaltet und es ergibt sich ein besseres Offset-Verhalten und eine bessere Verstärkungscharakteristik, so daß eine höhere Genauigkeit erreicht werden kann. Allerdings muß der optimale Wert für die Koppelkapazität CBK des Teil-Wandlernetzwerks LN möglichst genau bestimmt werden. Bei falscher Auslegung kann es mit zunehmender Anzahl der Wichtungskapazitäten des Teil-Wandlernetzwerks LN, d.h. mit zunehmender Bit-Auflösung, zu Anpassungsfehlern kommen, die sich im unkalibrierten Fall in gesteigerten Nichtlinearitäten, insbesondere differentiellen Nichtlinearitäten äußern. Dieser Effekt kann allerdings kompensiert werden durch Layout- und schaltungstechnische Maßnahmen, z.B. durch Minimierung der Streukapazitäten oder Vergrößerung der Gesamtkapazität des Teil-Wandlernetzwerks LN. Im übrigen bleibt weiterhin die Möglichkeit, einen ggf. nicht optimal ausgelegten Wert für die Koppelkapazität CBK im Zuge der normalen Selbstkalibrierung zu ermitteln und bei der Wandlung zu korrigieren.

Mit dem im Ausführungsbeispiel beschriebenen A/D-Wandler kann auf übliche Weise ein D/A-Wandler realisiert werden.

**Patentansprüche**

1. Selbstkalibrierender A/D- und D/A-Wandler nach dem Prinzip der Ladungsumverteilung mit einem gewichteten kapazitiven Haupt-Wandlernetzwerk (MN) für die höchstwertigen Bits, dessen Kapazitäten (CAi) jeweils mit einem Anschluß an einem Knotenpunkt (Kp) liegen, der mit einem Eingang eines Komparators (K) verbunden ist, und mit einem gewichteten kapazitiven Teil-Wandlernetzwerk (LN) für die niedrigerwertigen Bits, dessen Kapazitäten (CBi) jeweils mit einem Anschluß über einen Koppelkondensator (CBK) an dem Knotenpunkt (Kp) angeschlossen sind, wobei die jeweils anderen Anschlüsse der Kapazitäten (CAi, CBi) des Haupt-Wandlernetzwerks (MN) und des Teil-Wandlernetzwerks (LN) über jeweils einen, von einer Wandler-Kontrollogik (SAR) gesteuerten Schalter mit einem von mehreren vorgegebenen Potentialen (UR1, UR2) verbindbar sind und mit einem kapazitiven, mit dem Knotenpunkt (Kp) verbundenen Kalibrier und Korrekturnetzwerk (CN),
   **dadurch gekennzeichnet**,
   daß der Knotenpunkt (Kp) ohne Zwischenschaltung aktiver Schaltungselemente mit dem Komparator (K) verbunden ist, daß die kleinste Wichtungskapazität (CB2, CB3) des Teil-Wandlernetzwerks (LN) doppelt vorgesehen ist und
   daß die Kapazitäten (CCi) des Kalibrier- und Korrekturnetzwerks (CN) mit jeweils einem Anschluß über einen weiteren Koppelkondensator (CCK) an dem Knotenpunkt (Kp) angeschlossen sind und mit dem jeweils anderen Anschluß über jeweils einen von der Wandler-Kontrollogik (SAR, KRE) gesteuerten Schalter mit einem der vorgegebenen Potentiale (UR1, UR2) verbindbar sind.

2. Wandler nach Anspruch 1, **dadurch gekennzeichnet,** daß die beiden Wandlernetzwerke (MN, LN) und das Kalibrier- und Korrekturnetzwerk (CN) wertmäßig unabhängig voneinander jeweils binäre Wichtungskapazitäten (CAi, CBi, CCi) aufweisen.

3. Wandler nach einem der Ansprüche 1 oder 2, **dadurch gekennzeichnet,** daß das Teil-Wandlernetzwerk (LN) eine Korrekturkapazität (CB1) für das niedrigstwertige Bit enthält, die wertmäßig der Hälfte der kleinsten Wichtungskapazität (CB2, CB3) entspricht.

4. Wandler nach einem der Ansprüche 1 bis 3, **dadurch gekennzeichnet,** daß die Anzahl der Wichtungskapazitäten (CAi, CB3 bis CBn) in den beiden Wandlernetzwerken (MN, LN) der Bit-Auflösung des Wandlers entspricht und daß das Haupt-Wandlernetzwerk (MN) gegenüber dem Teil-Wandlernetzwerk (LN) eine mindestens gleiche Zahl Wichtungskapazitäten enthält.

5. Wandler nach einem der Ansprüche 2 bis 4, **dadurch gekennzeichnet,** daß die kleinste Wichtungskapazität (CB2) des Teil-Wandlernetzwerks (LN) etwa dem doppelten Wert der kleinsten Wichtungskapazität (CA1) des Haupt-Wandlernetzwerks (MN) entspricht.

6. Wandler nach einem der Ansprüche 2 bis 5, **dadurch gekennzeichnet,** daß die Anzahl der Wichtungskapazitäten (CCi) des Kalibrier- und Korrekturnetzwerks (CN) wählbar ist und insbesondere etwa der halben Bit-Auflösung des Wandlers entspricht.

7. Wandler nach einem der Ansprüche 2 bis 6, **dadurch gekennzeichnet,** daß die kleinste Wichtungskapazität (CC1) des Kalibrier- und Korrekturnetzwerks (CN) etwa halb so groß wie die kleinste Wichtungskapazität (CA1) des Haupt-Wandlernetzwerks (MN) ist.

8. Wandler nach einem der Ansprüche 2 bis 7, **dadurch gekennzeichnet,** daß der 1- bis 1,4-fache Wert der kleinsten Wichtungskapazität (CA1) des Haupt-Wandlernetzwerks (MN) dem Wert der Koppelkapazität (CBK) für das Teil-Wandlernetzwerk (LN) entspricht.

9. Wandler nach einem der Ansprüche 2 bis 8, **dadurch gekennzeichnet,** daß der 0,1- bis 1-fache Wert der kleinsten Wichtungskapazität (CA1) des Haupt-Wandlernetzwerks (MN) dem Wert der Koppelkapazität (CCK) für das Kalibrier- und Korrekturnetzwerk (CN) entspricht.

**Claims**

1. Self-calibrating A/D and D/A converter operating according to the principle of charge redistribution, having a weighted capacitive primary converter network (MN) for the most significant bits, the capacitors (CAi) of which are connected with in each case one terminal to a node (Kp), which is connected to one input of a comparator (K), and having a weighted capacitive subsidiary converter network (LN) for the less significant bits, the capacitors (CBi) of which are connected with in each case one terminal to a node (Kp) via a coupling capacitor (CBK), in which the respective other terminals of the capacitors (CAi, CBi) of the primary converter network (MN) and of the subsidiary converter network (LN) can be connected to one of several predetermined potentials (UR1, UR2) via in each case one switch controlled by a converter control logic means (SAR), and having a capacitive calibration and correction network (CN) connected to the node (Kp), characterized in that the node (Kp) is connected to the comparator (K) without the insertion of active circuit elements, in that the smallest weighting capacitor (CB2, CB3) of the subsidiary converter network (LN) is provided in duplicate, and in that the capacitors (CCi) of the calibration and correction network (CN) are connected with in each case one terminal via a further coupling capacitor (CCK) to the node (Kp), and can be connected with in each case the respective other terminal to one of the predetermined potentials (UR1, UR2) via a switch controlled by the converter control logic means (SAR, KRE).

2. Converter according to Claim 1, characterized in that the two converter networks (MN, LN) and the calibration and correction network (CN) have in each case binary weighting capacitors (CAi, CBi, CCi) whose values are independent of one another.

3. Converter according to one of Claims 1 or 2, characterized in that the subsidiary converter network (LN) contains a correction capacitor (CB1) for the least significant bit whose value corresponds to half the smallest weighting capacitor (CB2, CB3).

4. Converter according to one of Claims 1 to 3, characterized in that the number of weighting capacitors (CAi, CB3 to CBn) in the two converter networks (MN, LN) corresponds to the bit resolution of the converter, and in that the primary converter network (MN) contains at least the same number of weighting capacitors as the subsidiary converter network (LN).

5. Converter according to one of Claims 2 to 4, characterized in that the smallest weighting capacitor (CB2) of the subsidiary converter network (LN) corresponds approximately to twice the value of the smallest weighting capacitor (CA1) of the primary converter network (MN).

6. Converter according to one of Claims 2 to 5, characterized in that the number of weighting capacitors (CCi) of the calibration and correction network (CN) is selectable, and preferably corresponds to approximately half the bit resolution of the converter.

7. Converter according to one of Claims 2 to 6, characterized in that the smallest weighting capacitor (CC1) of the calibration and correction network (CN) is approximately half the size of the smallest weighting capacitor (CA1) of the primary converter network (MN).

8. Converter according to one of Claims 2 to 7, characterized in that 1-times to 1.4-times the value of the smallest weighting capacitor (CA1) of the primary converter network (MN) corresponds to the value of the coupling capacitor (CBK) for the subsidiary converter network (LN).

9. Converter according to one of Claims 2 to 8, characterized in that 0.1-times to 1-times the value of the smallest weighting capacitor (CA1) of the primary converter network (MN) corresponds to the value of the coupling capacitor (CCK) for the calibration and correction network (CN).

**Revendications**

1. Convertisseur analogique/numérique et numérique/analogique à auto-étalonnage fonctionnant selon le principe de la redistribution des charges, comportant un réseau (MN) capacitif pondéré principal convertisseur pour les bits de poids forts, dont les capacités (CAi) sont chacune connectées par une borne à un noeud (Kp), relié à une entrée d'un comparateur (K), et un réseau (LN) capacitif pondéré partiel convertisseur pour les bits de poids faible, dont les capacités (CBi) sont chacune connectées par une borne au noeud (Kp) par l'intermédiaire d'un condensateur (CK) de couplage, les autres bornes respectives des capacités (CAi, CBi) du réseau (MN) principal convertisseur et du réseau (LN) partiel convertisseur pouvant être reliées à l'un de plusieurs potentiels (UR1, UR2) prescrits, par l'intermédiaire respectivement d'un interrupteur commandé par une logique (SAR) de contrôle du convertisseur, et un réseau (CN) capacitif d'étalonnage et de correction, relié au noeud (Kp),
caractérisé en ce que,
le noeud (Kp) est relié au comparateur (K) sans montage intercalaire d'éléments de circuit actifs,
la plus petite capacité (CB2, CB3) de pondération du réseau (LN) partiel convertisseur est prévue en double, et
les capacités (CCi) du réseau (CN) d'étalonnage et de correction sont connectées, par respectivement une borne, au noeud (Kp), par l'intermédiaire d'un autre condensateur (CCK) de couplage et peuvent être reliées, par l'autre borne respective, à l'un des potentiels (UR1, UR2) prescrits, par l'intermédiaire d'un interrupteur respectif commandé par la logique (SAR, KRE) de contrôle du convertisseur.

2. Convertisseur suivant la revendication 1, caractérisé en ce que les deux réseaux (MN, LN) convertisseurs et le réseau (CN) d'étalonnage et de correction comprennent des capacités (CAi, CBi, CCi) binaires respectives de pondération, qui ont des valeurs indépendantes.

3. Convertisseur suivant l'une des revendications 1 ou 2, caractérisé en ce que le réseau (LN) partiel convertisseur comprend une capacité (CB1) de correction pour le bit de poids faible, dont la valeur correspond à la moitié de la plus petite capacité (CB2, CB3) de pondération.

4. Convertisseur suivant l'une des revendications 1 à 3, caractérisé en ce que le nombre des capacités (CAi, CB3 à CBn) de pondération dans les deux réseaux (MN, LN) convertisseurs correspond à la résolution en bits du convertisseur et que le réseau (MN) principal convertisseur comprend au moins le même nombre de capacités de pondération que le réseau (LN) partiel convertisseur.

5. Convertisseur suivant l'une des revendications 2 à 4, caractérisé en ce que la plus petite capacité (CB2) de pondération du réseau (LN) partiel convertisseur correspond approximativement au double de la plus petite capacité (CA1) de pondération du réseau (MN) principal convertisseur.

6. Convertisseur suivant l'une des revendications 2 à 5, caractérisé en ce que le nombre des capacités (CCi) de pondération du réseau (CN) d'étalonnage et de correction peut être sélectionné et correspond notamment approximativement à la moitié de la résolution en bits du convertisseur.

7. Convertisseur suivant l'une des revendications 2 à 6, caractérisé en ce que la plus petite capacité (CA1) de pondération du réseau (CN) d'étalonnage et de correction est égale approximativement à la moitié de la plus petite capacité (CA1) de pondération du réseau (MN) principal convertisseur.

8. Convertisseur suivant l'une des revendications 2 à 7, en ce que 1 à 1,4 fois la valeur de la plus petite capacité (CA1) de pondération du réseau (MN) principal convertisseur correspond à la valeur de la capacité (CBK) de couplage pour le réseau (LN) partiel convertisseur.

9. Convertisseur suivant l'une des revendications 2 à 8, caractérisé en ce que 0,1 à 1 fois la valeur de la plus petite capacité (CA1) de pondération du réseau (MN) principal convertisseur correspond à la valeur de la capacité (CCK) de couplage pour le réseau (CN) d'étalonnage et de correction.

EP 0 360 914 B1